Europäisches Patentamt

European Patent Office

Office européen des brevets

(19)

(11) Veröffentlichungsnummer: **0 217 063 B1**

(12) **EUROPÄISCHE PATENTSCHRIFT**

(45) Veröffentlichungstag der Patentschrift:
13.06.90

(51) Int. Cl.⁵: **G02B 6/42**

(21) Anmeldenummer: 86110751.4

(22) Anmeldetag: 04.08.86

(54) Optische Anordnung.

(30) Priorität: 05.09.85 DE 3531734

(43) Veröffentlichungstag der Anmeldung:
08.04.87 Patentblatt 87/15

(45) Bekanntmachung des Hinweises auf die Patenterteilung:
13.06.90 Patentblatt 90/24

(84) Benannte Vertragsstaaten:
CH DE FR GB LI

(56) Entgegenhaltungen:
EP-A- 0 006 042
FR-A- 2 426 271
US-A- 4 466 696

IBM TECHNICAL DISCLOSURE BULLETIN, Band 23,
Nr. 7B, Dezember 1980, Seiten 3104-3106, New York, US;
L. BALLIET et al.: "Self-aligning edge emitter for fiber
optics"
IEEE TRANSACTIONS ON ELECTRON DEVICES, Band
ED-26, Nr. 8, August 1979, Seiten 1215-1220, IEEE, New
York, US; R.C. GOODFELLOW et al.: "GaInAsP/InP fast,
high-radiance, 1.05-1.3-mum wavelength LED's with
efficient lens coupling to small numerical aperture silica
optical fibers"-aminoalkyl)succinimides" 000

(73) Patentinhaber: Siemens Aktiengesellschaft,
Wittelsbacherplatz 2, D-8000 München 2(DE)

(72) Erfinder: Heinen, Jochen, Dr.-Ing., Dianastrasse 38,
D-8013 Haar(DE)
Erfinder: Weidinger, Friedrich, Dipl.-Ing.,
Rosenstrasse 50, D-8028 Taufkirchen(DE)

## Beschreibung

Die vorliegende Erfindung bezieht sich auf eine optische Anordnung mit einer Glasfaser, einem Halbleiterlaser und einer Einrichtung zur Ankopplung der Glasfaser an den Halbleiterlaser.

Für nachrichtentechnische Übertragung werden einerseits Glasfaserleitungen und andererseits optische Strahlung erzeugende Halbleiterelemente verwendet, wobei besonderes Interesse an der Verwendung von Laserdioden besteht. Bekanntermaßen erzeugen Laserdioden relativ scharf gebündelte Strahlung. Der Querschnitt der Strahlungs-Austrittsfläche auf der Oberfläche des Halbleiterkörpers, in dem diese Laserstrahlung nach bekanntem Prinzip erzeugt wird, ist vergleichsweise klein und hat eine (verallgemeinert als Durchmesser angesprochene) Abmessung von wenigen μm. Da die verwendete Glasfaserleitung einen für die Fortpflanzung der Strahlung wirksamen Querschnitt vergleichbarer Abmessung besitzt, bedarf es erheblichen Aufwandes für genügend genaue Justierung des Eintrittsquerschnittes der Glasfaserleitung und einer Laserdiode zueinander. Nur bei Einhaltung genügend kleiner Toleranzen von wenigen μm für die Justierung ist eine gute Einkopplung der Laserstrahlung in die Glasfaserleitung zu gewährleisten.

Aus der US-PS 4 411 057 (europäische Patentanmeldung 0006 042) ist eine Justiervorrichtung bekannt, die einen Justierkörper aus einem Material aufweist, das mit einem Preßstempel verformbar ist. Für die Glasfaser wird eine V-förmige Nut eingepreßt und für die Laserdiode ist eine ebene Vertiefung eingepreßt, deren Seitenwände so große Abstände voneinander haben, daß die Laserdiode in dieser Vertiefung um ein erhebliches Maß seitlich verschiebbar angebracht werden kann.

Aus der US-PS 4 466 696 ist eine Justiervorrichtung bekannt, bei der in den Substratkörper der Laserdiode eine V-förmige Nut zur Aufnahme der Glasfaser eingeätzt ist. Da sich die V-förmige Nut in dem Körper der Laserdiode befindet, ist zwar eine einmal erreichte Positionierung dauerhaft festgelegt. Das Ätzen der V-förmigen Nut und die komplizierte technologische Herstellung der Laserdiode mit Epitaxieschritten und dgl. sind dort aber an ein und demselben Körper durchzuführen, was wegen der Unterschiedlichkeit der jeweiligen, zeitlich nacheinander durchzuführenden Maßnahmen das gesamte Herstellungsverfahren sehr wesentlich kompliziert.

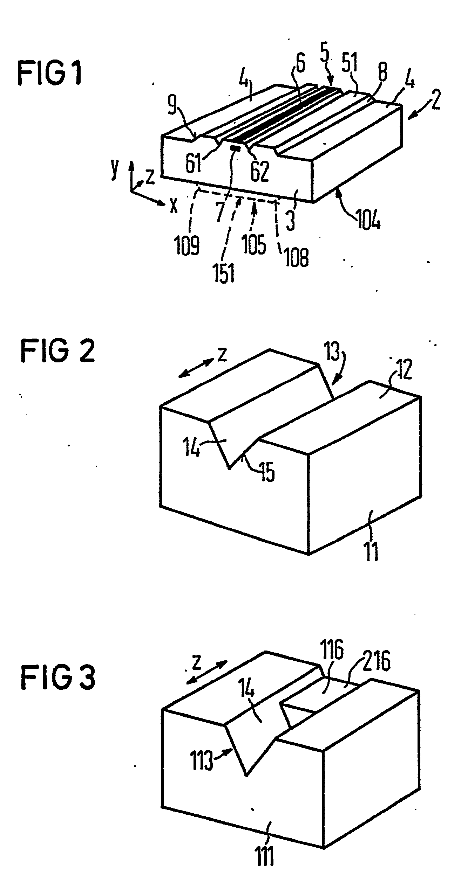

Aus Appl. Phys. Letters, Bd. 45 (1984), S. 729 bis 731, insbesondere Figur 1, ist eine Justierung bekannt, bei der zwei aneinanderstoßende Körper vorhanden sind. Der eine dieser Körper trägt die Laserdiode. Der an den ersten Körper anstoßende zweite Körper bildet mit dem ersten Körper eine querlaufende rechteckige Vertiefung, in die ein Kapillarrohr eingelegt ist.

In IBM Techn. Disclosure Bulletin, Bd. 23 (1980), S. 3104 bis 3106, insbesondere Figuren 1 und 2, ist ein Halbleiterkörper angegeben, der eine V-förmige Nut besitzt, in die eine Glasfaser einzulegen ist. Die eigentliche Laserdiode ist Bestandteil dieses Körpers. Bestandteil der eigentlichen Diodenfunktion ist eine in der Oberfläche des Körpers vorgesehene Rinne mit schrägen Flanken. Zwischen diesen schrägen Flanken liegt die auf der Oberseite des Körpers befindliche Metallelektrode in dieser Rinne vertieft auf dem Halbleitermaterial des Körpers dieser Laserdiode auf. Zu dieser Rinne gibt es dort keinen weiteren Körper, der mit Hilfe dieser Rinne irgendwie justiert werden sollte oder könnte.

Aus der DE-OS 3 330 392 ist eine Laserdiode bekannt, die sich auf einem Kühlkörper befindet. In dem Kühlkörper ist eine V-förmige Nut vorgesehen. Die auf dem Kühlkörper aufgelötete Laserdiode kann zur Justierung der Laserdiode auf diesem Kühlkörper verwendet werden. Die Hauptfunktion dieser Nut ist jedoch, die auf dem Kühlkörper aufgelötete Laserdiode von störenden mechanischen Spannungen freizuhalten, die ansonsten von dem Kühlkörper auf die Laserdiode ausgeübt werden könnten. Justierungsfunktion hinsichtlich einer angekoppelten Glasfaser kann diese Nut im Kühlkörper nicht ausführen.

Aufgabe der vorliegenden Erfindung ist es, eine Anordnung mit selbstjustierender Wirkung für die Positionierung eines Halbleiterlasers und einer Glasfaser zueinander anzugeben. Insbesondere soll diese Anordnung so ausgebildet sein, daß Temperatureffekte die Justierung nicht merklich beeinträchtigen.

Diese Aufgabe wird mit einer Anordnung gelöst, die die Merkmale des Patentanspruches 1 aufweist und weitere Ausgestaltungen und Weiterbildungen der Erfindung gehen aus den Unteransprüchen hervor.

Der vorliegenden Erfindung liegt als ein Ausgangspunkt der Gedanke zugrunde, für einen Justierkörper eine solche Form vorzusehen und solches Material zu verwenden, das spezifische Eigenschaften hat, die geeignet sind, am Justierkörper aus diesem Material Flächen zu erzeugen, die zur exakten Positionierung herangezogen werden können. Für die Erfindung verwendet man aus diesem Grunde für einen derartigen Körper der erfindungsgemäßen Einrichtung ein als Kristall vorliegendes Halbleitermaterial. Durch selektive Ätzung werden an dem Körper solche Positionierflächen erzeugt, die orientierte Kristallflächen sind. Zum Beispiel ist hierfür Silizium zu verwenden, vorzugsweise als Einkristall.

Erfindungsgemäß ist vorgesehen, in dem Justierkörper aus Halbleitermaterial eine V-Nut durch maskierte, selektive Ätzung herzustellen. Zum Beispiel wird in einem Silizium-Kristallkörper mit 100-orientierter Oberfläche eine V-Nut eingeätzt, für deren Seitenflächen sich 111-Flächen des Kristalls ergeben. Die beiden V-orientiert zueinander stehenden 111-Flächen bilden exakt und ohne daß dazu besonderer technologischer Aufwand erforderlich wäre, einen Winkel β von 70.52° zueinander. Zum Beispiel ist dies ein Winkel, der sich gut dafür eignet, in dieser V-Nut bzw. zwischen deren 111-Seitenflächen, eine Glasfaser aufzunehmen. Die Tiefe der V-Nut und der vorgegebene Durchmesser der Glasfaser werden relativ zueinander so bemessen, daß die in diese Nut eingelegte Glasfaser eine außerordentlich exakte x-y-Positionierung für die Lage des für die Ankopplung entscheidenden Faserkernes hat. Mit diesen Gedanken und Merkmalen erschöpft sich die Erfindung jedoch noch nicht.

Der Erfindung liegt nämlich weiter der Gedanke zugrunde, Maßnahmen zu finden, mit denen auch der Halbleiterchip des Halbleiterlasers, und zwar bezogen auf die V-Nut, zu positionieren ist. Für zwei der Alternativen von Konkretisierungen dieses Teils des gesamten Erfindungsgedankens erweist sich der Umstand als günstig, daß Halbleiterlaser so aufgebaut sein können, daß der Laserchip auf einem Substratkörper einen Steg aus mehrfach übereinanderliegend aufgebrachten Epitaxieschichten hat. Einer günstigen Realisierung der geometrischen Form eines Halbleiterlasers kommt eine solche Form entgegen, bei der schräg zueinander stehende Flächen des Steges auftreten. Zum Beispiel kann man einen Laserchip der Figur 1 der US-PS 4 352 187 mit Mesasteg versehen. Geht man z.B. von einer 100-Oberfläche des Laserchips aus, so lassen sich sehr leicht 111-Flankenflächen des Mesasteges herstellen. Ein solcher Mesasteg bekannter Laserdioden hat wahlweise 5 bis 50 μm Höhe. Die Basisbreite des Mesasteges kann durch Fotoresisttechnik sehr exakt eingestellt werden und kann auch gleich der Gesamtbreite des Chips sein, und zwar ohne daß dies während des an sich bekannten Herstellungsverfahrens des Laserchips nach den Prinzipien der Epitaxie irgendwelche besondere Technologie erfordern würde.

Die eine der oben angesprochenen Alternativen ist, daß der Mesasteg identisch mit dem aktiven Mesasteg der Laserdiode des obengenannten US-Patentes ist. Eine zweite Alternative ist einen (dagegen breiteren) Mesasteg vorzusehen, innerhalb dessen sich, von zwei V-förmigen Kerben seitlich begrenzt, der aktive Mesasteg dieses US-Patentes befindet.

Es ist ebenfalls problemlos und Stand der erreichten Technologie, derartige Laserchips herzustellen, bei denen die laseraktive Zone, d.h. diejenige Zone, an deren an der Halbleiteroberfläche liegenden Querschnittsfläche die Laserstrahlung austritt, ein genau festzulegendes Maß bezogen auf den Mesasteg hat. Der Mesasteg kann wahlweise auf der Substratoberseite oder -unterseite angebracht sein. Der Laserstreifen liegt infolge der angewendeten fototechnischen Mittel exakt in der Mitte des Mesasteges. Es ergibt sich also, daß die x, y-Position der laseraktiven Zone des Laserchips exakt vorgegeben werden kann, und zwar bezogen auf die Substratoberfläche des Chips. Da auch - wie oben bereits ausgeführt - der Faserkern einer in die V-Nut eingelegten Glasfaser in seiner x, y-Position durch entsprechende Abmessungsanpassung exakt vorgegeben werden kann, lassen sich Glasfaser und Laserdiode hinsichtlich des Faserkerns einerseits und der laseraktiven Zone andererseits außerordentlich genau, und zwar in x-Richtung und in y-Richtung selbstjustierender Weise zueinander positionieren. Die Positionierung in z-Richtung ist an sich unkritisch und wird durch Manipulation eingestellt, für die Abstandswerte zwischen 5 bis 30 μm einzustellen sind, ehe man Faser und Laserchip in der V-Nut mit dem Körper, in dem sich die V-förmige Nut befindet, fest und dauerhaft verbindet.

Für diese endgültige Befestigung ist es von Vorteil, die aufeinanderliegenden Oberflächen des Laserchips einerseits und der V-Nut andererseits mit Metallschichten zu versehen, den auf dem Justierkörper mit der V-Nut aufgelegten Laserchip z.B. durch Rütteln einwandfrei anliegend aufzubringen und diesen Justierkörper und den Laserchip miteinander zu verlöten.

Eine dritte Alternative ist den Mesasteg dem "aktiven" Mesasteg gegenüberliegend anzuordnen.

Weitere Erläuterungen der Erfindung gehen aus der nachfolgenden, anhand der Figuren gegebenen Beschreibung eines Ausführungsbeispiels der Erfindung hervor.

Figur 1 zeigt einen Laserchip mit einer für die Erfindung angepaßten Form mit Mesasteg, der außerdem (2. Alternative) V-förmige Kerben hat.

Figur 2 zeigt einen erfindungsgemäß zu verwendenden Justierkörper mit V-Nut.

Figur 3 zeigt eine Variante zur Figur 2 und

Figur 4 zeigt in stirnseitiger Ansicht die gesamte Anordnung mit positioniertem Laserchip und dazu positionierter Glasfaser.

Figur 5 zeigt eine seitliche (Schnitt-)Ansicht der Figur 4.

Der Laserchip 2 in Figur 1 besteht, wenigstens für die vorliegende Erfindung, im wesentlichen aus einem Halbleiter-Substratkörper 3 und dem auf der oberen Oberfläche 4 dieses Substratkörpers 3 vorhandenen Mesasteg 5. Der Mesasteg 5 ist mit dem Substratkörper 3 einstückig verbunden und besteht aus mehreren aufeinanderliegenden epitaktisch aufgebrachten Schichten. Mit 6 ist eine streifenförmige, auf der Oberfläche 51 des Mesasteges 5 befindliche Elektrode bezeichnet. In x-Richtung ist die Lage der laseraktiven Zone 7 (von der in Figur 1 nur die Austritts-Querschnittsfläche in der stirnseitigen Oberfläche des Laserchips 2 zu sehen ist) durch die Positionierung des Elektrodenstreifens 6 gegeben. In y-Richtung ist die Lage dieser laseraktiven Zone 7 durch den epitaxialen Schichtaufbau gegeben. Die voranstehend erwähnten Einzelheiten der Laserdiode nach Figur 1 sind prinzipiell bekannt, z.B. aus der obengenannten US-PS, und bedürfen für den Fachmann keiner noch eingehenderen Beschreibung.

Für die Erfindung jedoch wichtig ist, daß die beiden Seiten- bzw. Flankenflächen 8 und 9 des Mesasteges ein vorzugebender Winkel (z.B. bezogen auf die Oberfläche 4) einzuhalten ist, wobei diese gemäß einem Merkmal der Erfindung vorgesehene Maßnahme technologisch wiederum mit bekannten Mitteln einzuhalten ist, z.B. durch chemische Ätzung mit Kaliumdichromat, gelöst in Schwefelsäure und Salzsäure.

Nach der ersten Alternative ist der Mesasteg 5 der aktive Mesasteg des US-Patentes 4 352 187. Der zweiten Alternative gemäß hat der Mesasteg 5 vergleichsweise größere Breite und weist die zwei V-förmigen Kerben 61 und 62 auf. Diese zweite Al-

ternative hat einen Vorzug, nämlich daß sich mögliche mechanische Spannungen auf dem "aktiven" Mesasteg (zwischen den Kerben 61 und 62) weniger stark auswirken können.

Der Justierkörper (Fig. 2) ist ein Halbleiterkörper 11 und besteht z.B. aus Silizium, Galliumarsenid und dgl.. Zu bevorzugen ist kubisch kristallisierendes Halbleitermaterial. Für das vorliegende Beispiel ist eine Orientierung gewählt, bei der die dargestellte Oberfläche 12 des Halbleiterkörpers 11 eine 100-Kristallfläche ist. Durch an sich bekanntes Ätzen eines solchen Justierkörpers 11 auf bzw. an der Oberfläche 12 ist mit Hilfe entsprechender Maskierung eine wie dargestellte Nut 13 in die Oberfläche 12 und in den Halbleiterkörper 11 hineingeätzt werden. Aufgrund der gewählten Orientierung ergeben sich Seiten-bzw. Flankenflächen 14 und 15 der Nut 13, die eine V-Nut 13 entstehen läßt, deren Flankenflächen 111-Kristallflächen sind und die exakte Winkelorientierung im Halbleiterkörper haben.

Figur 3 zeigt eine nachfolgend noch näher zu erörternde Variante an einem Halbleiterkörper 111. Wie aus Figur 3 ersichtlich, ist in der V-förmigen Nut 113 (vergleichsweise zum Justierkörper 11 der Figur 2) noch ein Anteil 116 mit einer Oberfläche 216 stehengelassen. Derartiges ist ohne Schwierigkeiten durch Unterbrechung und Zwischenmaskierung im Ätzprozeß auszuführen.

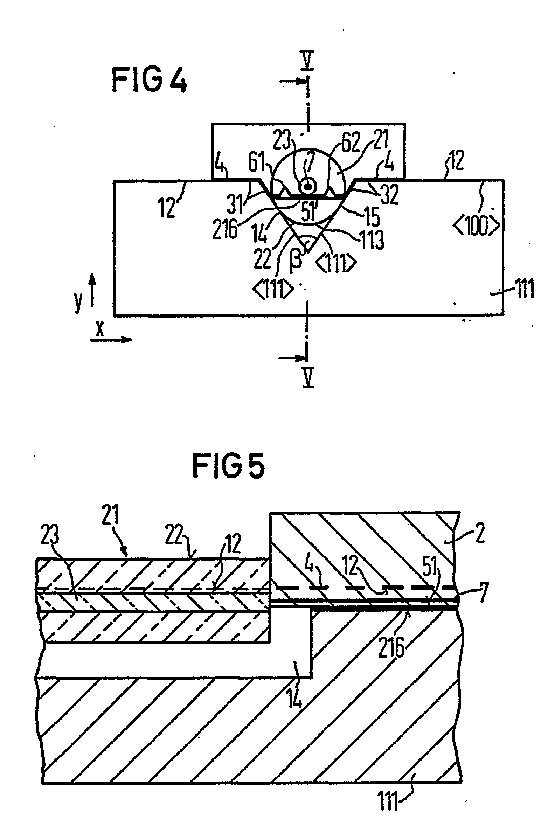

Die Darstellung der Figur 4 zeigt Einzelheiten, die mit mit den Figuren 1 bis 3 übereinstimmenden Bezugszeichen versehen sind. Übereinstimmendes Bezugszeichen bedeutet übereinstimmende Bedeutung der betreffenden Einzelheit der Darstellung.

Der Justierkörper 111, der sinngemäß auch ein Justierkörper 11 sein kann, ist so dargestellt, daß die V-Nut bzw. die Z-Achse senkrecht auf der Darstellungsebene steht. In gegenüber der Figur 1 umgekehrter Lage (up-side-down-Positionierung) liegt der Laserchip 2 auf dem Justierkörper 111 auf. Dabei liegen die Chipoberfläche 4 und die Oberfläche 12 des Justierkörpers 11, 111 wie ersichtlich übereinander, vorzugsweise dicht aufeinander. Auf jeden Fall liegen aber die Seitenflächen 8, 9 des Mesasteges 5 dicht anliegend auf den Flankenflächen 14 und 15 der V-Nut auf. Das Anliegen dieser Seitenflächen bzw. Flankenflächen bewirkt die exakte Positionierung des Laserchips 2 auf bzw. an dem Justierkörper 11, 111.

Die in Figur 4 mit 21 bezeichnete Glasfaser 21 (von der in Figur 4 der Querschnitt dargestellt ist) liegt wie ersichtlich in der V-Nut 113. Dabei liegt die äußere Oberfläche 22 der Glasfaser 21 dicht auf den Flankenflächen 14 und 15 der V-Nut 113 an. Mit 23 ist der eigentliche Faserkern bezeichnet, der für die Lichtübertragung mittels der Glasfaser 21 in Betracht kommt.

Wie aus Figur 4 ersichtlich, sind dieser Faserkern 23 und die laseraktive Zone 7 außerordentlich exakt zueinander justiert, und zwar in selbstjustierender Weise. Die exakte Selbstjustierung gewährleistet die Kristallorientierung der Flankenflächen 14, 15 und der Seitenflächen 8, 9 des Mesasteges 5, sowie der ohnehin exakt eingehaltene Durchmesser der Glasfaser 21. Mit 31 und 32 ist auf ein Verlöten der aneinanderliegenden Flächen des Laserchips und des Halbleiterkörpers 111 hingewiesen. Bei einer Breite des Mesasteges gleich der Breite des. Chip erfolgt die Verlötung auf der Oberfläche 216.

Mit dem Bezugszeichen 116 ist in Figur 4 auf das Vorhandensein des zur Figur 3 bereits beschriebenen Anteils 116 hingewiesen. Die Oberfläche 216 (diese Oberfläche 216 ist in Figur 5 durch gestrichelte Darstellung erkennbar gemacht) und die Oberfläche 51 des Mesasteges 5 liegen vorteilhafterweise dicht auf- bzw. aneinander. Eine solche Anordnung bietet den Vorteil einer guten Wärmeableitung aus dem Laserchip 2 über den Anteil 116 in den Halbleiterkörper 111.

Die zur Figur 4 gehörige Seitenansicht der Figur 5 enthält die bereits zu den Figuren 1 bis 4 beschriebenen Bezugszeichen. Die Figur 5 ergänzt das Verständnis zur Figur 4 ohne daß es besondere weitere Erörterungen bedarf. Die Figur 5 gibt die Ansicht der in Figur 4 angegebenen Schnittebene wieder.

In Figur 1 ist gestrichelt noch auf eine dritte Alternative hingewiesen. Es ist dort (zusätzlich) ein Mesasteg 105 mit Flanken 108, 109 und einer Oberfläche 151 vorgesehen, der an der, bezogen auf die Lage der laseraktiven Zone 7, gegenüberliegenden Oberfläche 104 des Laserchips 2 vorgesehen ist. Dieser Mesasteg wird bei dieser Alternative in die Nut 13, 113 passend eingesetzt. Dieser Positionierung entsprechend sind dann der Durchmesser der Faser 21 und/oder die Abmessung der V-Nut 13, 113 im Justierkörper 11, 111 der Lage der laseraktiven Zone 7 angepaßt zu bemessen. Diese Alternative hat den Vorzug, daß keine mechanischen Spannungen auf die laseraktive Zone 7 einwirken, die auftreten könnten.

## Patentansprüche

1. Optische Anordnung mit einer Glasfaser (21), einem Halbleiterlaser und einer Einrichtung zur Ankopplung der Glasfaser (21) an den Halbleiterlaser, der eine vorgegebene, laseraktive Zone (7) aufweist;
   — mit einem Laserchip (2) mit einem Halbleiter-Substratkörper (3),
   — wobei der Substratkörper (3) einen Mesasteg (5, 105) mit einer Oberfläche (51, 151) und mit zur Oberfläche (4, 104) des Substratkörpers (3) schrägen Flanken (8, 9; 108, 109) aufweist,
   — mit einem Justierkörper (11, 111) aus Halbleitermaterial,
   — der eine geätzte V-förmige Nut (13, 113) in seiner Oberfläche (12) hat,
   — wobei diese Nut (13, 113) hinsichtlich Breite und Flankenwinkel β so bemessen ist, daß der Kern (23) der mit ihrem einen Ende in die Nut (13, 113) eingelegten Glasfaser (21, Fig. 5) und die laseraktive Zone (7) des Laserchip (2) zueinander genau positioniert sind, wobei der Laserchip (2) mit dem Mesasteg (5, 105) in diese Nut (13, 113) eingepaßt an dem Justierkörper (11, 111) befestigt ist.

2. Anordnung nach Anspruch 1, gekennzeichnet dadurch, daß der Laserchip (2) am Justierkörper (11, 111) angelötet ist.

3. Anordnung nach Anspruch 1 oder 2, gekennzeichnet dadurch, daß der Justierkörper (111) in seiner Nut (113) einen Anteil (116, 216) aufweist, wobei der Laserchip (2) an diesen Anteil (116, 216) angrenzend befestigt ist.

4. Anordnung nach Anspruch 1, 2 oder 3, gekennzeichnet dadurch, daß ein breiter Mesasteg (5) vorgesehen ist und in der Oberfläche (51) dieses Mesasteges (5) der laseraktiven Zone (7) parallel laufend Kerben (61, 62) vorgesehen sind, die wenigstens bis zur Tiefe der laseraktiven Zone (7) in den Laserchip (2) hineinreichen.

5. Anordnung nach einem der Ansprüche 1 bis 3, gekennzeichnet dadurch, daß der zur justierten Befestigung des Laserchips (2) an dem Justierkörper (11, 111) vorgesehene Mesasteg (105) auf der Oberfläche (104) des Substratkörpers (3) vorhanden ist, die (104) der Lage der laseraktiven Zone (7), diese Lage bezogen auf den Substratkörper (3), gegenüberliegend ist.

## Claims

1. Optical arrangement having a glass fibre (21), a semiconductor laser and a mechanism for coupling the glass fibre (21) to the semiconductor laser, which has a prescribed laser active zone (7),
- having a laser chip (2) with a semiconductor substrate member (3),
- the substrate member (3) having a mesa ridge (5, 105) with a surface (51, 151) and with side faces (8, 9; 108, 109) slanted with respect to the surface (4, 104) of the substrate member (3),
- having an adjustment member (11, 111) of semiconductor material,
- which has an etched V-shaped groove (13, 113) in its surface (12),
- this groove (13, 113) being dimensioned with respect to width and side angle β in such a way that the core (23) of the glass fibre (21, Fig. 5) inserted with its one end into the groove (13, 113) and the laser active zone (7) of the laser chip (2) are precisely positioned relative to one another, the laser chip (2) with the mesa ridge (5, 105) being fitted into this groove (13, 113) and being fastened to the adjustment member (11, 111).

2. Arrangement according to Claim 1, characterized in that the laser chip (2) is soldered to the adjustment member (11, 111).

3. Arrangement according to Claim 1 or 2, characterized in that the adjustment member (111) has in its groove (113) a portion (116, 216), the laser chip (2) being fastened in an adjoining manner to this portion (116, 216).

4. Arrangement according to Claim 1, 2 or 3, characterized in that a wide mesa ridge (5) is provided, and there are provided in the surface (51) of this mesa ridge (5) notches (61, 62) extending parallel to the laser active zone (7), said notches extending into the laser chip (2) at least to the depth of the laser active zone (7).

5. Arrangement according to one of Claims 1 to 3, characterized in that the mesa ridge (105) provided for the adjusted fastening of the laser chip (2) to the adjustment member (11, 111) is present on the surface (104) of the substrate member (3), which surface (104) is opposite the position of the laser active zone (7), this position being relative to the substrate member (3).

## Revendications

1. Dispositif optique comportant une fibre de verre (21), un laser à semiconducteurs et un dispositif pour accoupler la fibre de verre (21) au laser à semiconducteurs, qui possède une zone prédéterminée (7) active pour produire l'effet laser, et comportant
- une microplaquette laser (2) munie d'un corps formant substrat semiconducteur (3),
- le corps formant substrat (3) possédant une barrette mesa (5, 105) présentant une surface (51, 151) et des flancs (8, 9; 108, 109) obliques par rapport à la surface (4, 104) du corps formant substrat (3),
- un corps d'ajustement (11, 111) réalisé à un matériau semiconducteur,
- qui possède, dans sa surface supérieure (12), une rainure gravée en forme de V (13, 113),
- la largeur et l'angle β des flancs de cette rainure (13, 113) étant dimensionnés de manière que le noyau (23) de la fibre de verre (21, figure 5) inséré par l'une de ses extrémités dans la rainure (13, 113), et la zone (7), active pour produire l'effet laser, de la microplaquette laser (2) sont positionnés de façon précise l'un par rapport à l'autre, la microplaquette laser (2) étant fixée par la barrette mesa (5, 105), d'une manière adaptée dans cette rainure (13, 113), sur le corps d'ajustement (11, 111).

2. Dispositif suivant la revendication 1, caractérisé par le fait que la microplaquette laser (2) est fixée par soudage au corps d'ajustement (11, 111).

3. Dispositif suivant la revendication 1 ou 2, caractérisé par le fait que le corps d'ajustement (111) possède, dans sa rainure (113), une partie (116, 216), la microplaquette laser (2) étant fixée de façon contiguë à cette partie (116, 216).

4. Dispositif suivant la revendication 1, 2 ou 3, caractérisé par le fait qu'il est prévu une barrette mesa plus large (5) et qu'il est prévu, dans la surface (51) de cette barrette mesa (5), des encoches (61, 62), qui sont parallèles à la zone (7) active pour produire l'effet laser et s'étendent au moins jusqu'à la profondeur de la zone (7), active pour produire l'effet laser, dans la microplaquette laser (2).

5. Dispositif suivant l'une des revendications 1 à 3, caractérisé par le fait que la barrette mesa (105), prévue pour la fixation ajustée de la microplaquette laser (2) sur le corps d'ajustement (11, 111), est disposée sur la surface (104) du corps formant substrat (3), qui est située en vis-à-vis de la position de la zone (7), active pour produire l'effet laser, cette position étant rapportée au corps formant substrat (3).

FIG 1

FIG 2

FIG 3

FIG 4

FIG 5